Europäisches Patentamt

European Patent Office

Office européen des brevets

(11) Publication number: **0 125 883**
**A2**

# EUROPEAN PATENT APPLICATION

(21) Application number: **84303150.1**

(22) Date of filing: **10.05.84**

(51) Int. Cl.³: **G 06 F 15/20**

(30) Priority: **13.05.83 US 494322**

(43) Date of publication of application:
**21.11.84 Bulletin 84/47**

(84) Designated Contracting States:
**CH DE FR GB IT LI**

(71) Applicant: **DUFFERS SCIENTIFIC, INC.**
**R.D. 5, Box 85**
**Troy New York 12180(US)**

(72) Inventor: **Ferguson, Hugo Stanley**
**R.D. 2, Box 9**
**Averill Park New York 12180(US)**

(74) Representative: **McCallum, William Potter et al,**
**Cruikshank & Fairweather 19 Royal Exchange Square**
**Glasgow G1 3AE Scotland(GB)**

(54) Signal controlled waveform recorder.

(57) A multi-channel electronic waveform recorder for storing sampled waveform data and time of occurrence, information, i.e. a "time-tag", for each stored sample, is disclosed. Specifically, each channel (1, 2, 3...N) of the waveform recorder converts a previously stored digital sample of a recorded waveform into an analog value, compares this value to the current value of the input signal (1a, 2a, 3a ... Na), generates an analog difference signal in response to this comparison, and stores a digital sample substantially equivalent to the current value of the input signal whenever the magnitude of the difference signal exceeds a predetermined amount.

EP 0 125 883 A2

./...

# FIG. 1

## SIGNAL CONTROLLED WAVEFORM RECORDER

The invention relates to electronic waveform recorders and, more particularly, to those that can record a plurality of different signals and can be triggered to record these signals in response to a change occurring in any one of these signals.

The development and maintenance of any electrical or electromechanical system often requires an on-going analysis of a variety of analog signals, some of which represent inputs provided to the system and the remainder representing outputs generated by the system. However, for a variety of reasons, such an analysis can rarely be undertaken immediately upon the occurrence of these signals. Chief among these reasons is that any one of these signals may exist for only a relatively short period of time and/or occur only on a transient basis.

Consequently, a variety of electrical devices have commercially appeared or at least have been proposed in the art for recording analog signals, i.e., waveforms, for subsequent use, in, for example, system analysis. Generally, these devices fall into two broad classes: mechanical recorders and electronic recorders. Unfortunately, each class possesses a unique drawback which limits its utility.

Specifically, mechanical waveform recorders, typified by a chart recorder, rely on mechanical motion of a writing instrument, such as a pen, to record an electrical signal on a moving chart. By virtue of the inertia of the mechanical system in these recorders, the frequency response of these recorders is usually very low, typically from 5 to 10 Hz maximum. Consequently, these recorders are incapable of accurately recording relatively high frequency signals (100Hz and higher). However, since a chart recorder can be outfitted with a large roll of recording paper, widely spaced transients having a relatively low frequency content can be effectively recorded -- although with a considerable waste of paper.

Electronic waveform recorders, on the other hand, rely on converting input analog signals into digital data and storing the results in a digital memory, all at an extremely high speed. The stored analog signal can be subsequently retrieved either in digital form for subsequent processing or in analog form for display on a oscilloscope, for example. The rate at which the digital data can be read from the memory can usually be set to a different rate than that at which it was stored in order to either expand or compress the time scale of the displayed analog signals. While electronic waveform recorders can accurately record extremely fast signals, i.e. signals having a frequency content in excess of 100kHz, these recorders have a limited memory which disadvantageously restricts the total amount of stored data.

As the following example illustrates, the limited memory in electronic waveform recorders generally precludes these recorders from being able to record high speed transients which are widely spaced apart. Consider for the moment an analog signal that normally changes rather slowly for a period of two hours but does contain an occasional high frequency transient having a pulse width of 1 millisecond. Recording this transient with sufficient clarity might require 21 separate data points. This, in turn, necessitates that a sample be taken of the analog signal every 50 microseconds and stored in memory. To fully record two hours of such a signal, the recorder would require 144,000 K memory locations -- a prohibitive amount. Clearly, as the sampling rate (which determines the resolution of the recorded signal) and/or the recording time increases, so would the amount of required memory.

Consequently, early electronic waveform recorders relied on the use of a large mass memory, e.g. magnetic tape, to store transient waveforms. See, for example, H.H.Kajihara, "Power Transient Monitor," IEEE Transactions on Instrumentation and Measurement, February 1972, Pages 74-77. These recorders were disadvantageously large, complex and quite expensive.

An alternate solution to minimizing memory requirements, while still providing adequate capacity for long term high frequency transient recording, involved incorporating triggering circuitry into an electronic waveform recorder. In such systems, no samples were taken until the magnitude of an analog signal to be recorded crossed a pre-determined trigger value. To further minimize memory, one recent variation of these systems involves continuously taking and storing samples after a predetermined threshold has been crossed until a set amount (e.g. 1K or 2K) of the total memory (e.g. 4K) has been filled. When this occurs, sampling ceases until the

analog signal crosses the threshold again. Consequently, with this technique, multiple transient waveforms can be stored in the memory space previously used for one transient. However, in all of these systems, the user must choose the trigger values and sampling rates prior to recording. This presupposes that the user is thoroughly familiar with the amplitude and period (or pulse width) of the waveform to be recorded. Often this is not the case, as the waveform to be recorded is usually unknown and infrequently occurring. Thus, a substantial burden is placed on the user to choose the correct trigger values and sampling rates -- else the transient is erroneously recorded, if at all.

One solution known to the art is disclosed in U.S. Patent 3,225,333 (issued December 21, 1965 to A.W. Vinal). There, a single channel sampled data reduction and storage system is described in which each new sample of an incoming analog signal is digitized and compared with the value of the most recently stored sample of that signal. If the value of the new sample exceeds that of the most recently stored sample by a predetermined amount, then the value of this new sample is stored in a random access memory and this new sample now becomes the basis for the next succeeding comparison. If, on the other hand, the difference in value between these samples is less than the predetermined amount, then the new sample is ignored. The time-of-occurrence (commonly referred to as a "time-tag") of each stored sample is also stored in the memory along with the stored value. Disadvantageously, the system described in the '333 patent requires that all the samples be stored in various registers prior to any comparisons being made. Consequently, this, in turn, limits the dynamic (real-time) response of the system in the case of any rapidly occurring transient waveforms.

Moreover, while the circuitry described in the '333 patent is rather simple, its extensive and nearly exclusive reliance on digital processing disadvantageously complicates the circuitry of any multi-channel waveform recorder incorporating this circuit in the data recording circuitry for each channel. For example, one such multi-channel data storage system is disclosed in U.S. Patent 3,344,406 (issued September 26, 1967 to A.W. Vinal). While this multi-channel system possesses excellent capabilities, the nearly exclusive use of digital processing renders the overall circuitry disadvantageously complex and extremely expensive.

Another circuit for generating a sequence of samples of an analog waveform along with their corresponding "time-tags" is disclosed in F.R. Anderholm, "Time-tag Generator for Variable Sampling Rate Analog-to-Digital Converter," IBM Technical Disclosure Bulletin, Vol. 8, No. 11, April 1966, pages 1520-1521. Specifically, the time-tag generator described in this reference relies on a data compression circuit to monitor the rate of change in the analog signal and determine whether a particular sample is to be taken. However, dependent upon the manner in which the rate is calculated, an excessive number of samples may be produced and thus any waveform recorder incorporating this circuitry may well disadvantageously require an excessive amount of memory.

Accordingly, an object of the present invention is to provide a simple and inexpensive multi-channel electronic waveform recorder that is capable of accurately recording a plurality of analog waveforms.

Another object is to substantially eliminate the need for the operator to have any familiarity with the period (or pulse width) of the analog waveform.

A particular object is to accurately record a plurality of analog waveforms, each of which can have a frequency that widely varies from that of any other.

Another particular object is to accurately record any generally unknown and infrequently occurring transient waveform without requiring an excessive amount of memory.

Another object is to accurately record the time-of-occurrence of any recorded sample along with the value of that sample for any of the recorded waveforms.

A further object is to allow the operator to quickly and easily vary any of the comparison data for any of the channels while the recorder is operating.

These and other objects are achieved in accordance with the present invention by converting a previously stored digital sample of a recorded waveform into an analog value, comparing this analog value to the current value of the input signal, generating an analog difference signal in response thereto, and storing a digital sample substantially equivalent to the current value of this waveform whenever the magnitude of this difference signal exceeds a predetermined amount. Advantageously, performing the data comparisons, i.e. the data selection process, in an analog rather than a digital domain, ensures accurate dynamic (real-time) response to rapidly occurring transient waveforms and also substantially simplifies the circuitry for each channel of a multi-channel waveform recorder. In addition, converting the previously stored value of the input signal from the digital form in which it was stored into an analog form -- rather than using the previous value in its original analog form, advantageously imparts substantial long term stability to the operation of the circuitry in the waveform recorder, thereby greatly increasing the overall accuracy of the recorded waveform.

In accordance with a specific embodiment disclosed herein, the input signal is first sampled and converted, by, for example, an analog to digital (A/D) converter, into a stream of digital samples. The A/D converter is operated near its maximum rate such that the time interval between any two adjacent samples approximates this minimum time needed by the converter to completely and accurately perform a conversion. Whenever the A/D completes a conversion, the resulting digitized sample is stored in a first latch until the next successive conversion is complete. The digital data corresponding to this sample is then applied as input to both a second latch and to a random access memory.

To determine whether this sample is to be stored in the memory, an analog selection circuit compares this analog equivalent of the most recently stored sample to the then current value of the input signal. Specifically, the output of the second latch is continuously applied to the input of a digital to analog (D/A) converter. The analog output of this converter -- representing the analog equivalent of the most recently stored sample of the input signal, and the current value of the input signal are both applied as respective inputs to an analog subtractor which generates a signal indicative of the difference existing therebetween. This difference signal is applied to a comparator, illustratively a window comparator, which, in turn, ascertains whether the magnitude of the difference is within or outside a preselected range. If the magnitude is outside the range, the comparator generates a "TAKE" return signal. The "TAKE" return signal is then applied to system control circuitry, both to cause the random access memory to store the data present in the first latch -- the digitized value of the current sample. of the input signal -- and to transfer this data into the second latch which, in turn, applies this data as input to the D/A converter. Alternatively, if the magnitude of this difference signal is within the preselected range, then the current sample of the input signal is effectively ignored.

Because digital storage is inherently stable over prolonged periods, the output produced by the D/A converter is exceptionally stable. Therefore, the stability of the difference signal is substantially determined by variations in the input signal. Consequently, the determination to store any values of the input signal is essentially determined by variations in the input signal itself, and not by any external factors, such as drift, thermal changes, aging characteristics of the components or the like, occurring in the circuitry of the waveform recorder. This, in turn, eliminates a substantial source of error and thereby advantageously produces a far more accurately recorded waveform than would otherwise be possible.

To provide a "time-tag" for each stored sample of the input signal, a clock which operates the A/D converter is fed as an input to a counter. Whenever a value is stored in memory, the total count occurring at that time is stored in another memory at an address corresponding to the location where that sample is stored. As soon as the count has been stored, the contents of the counter are reset, to illustratively zero, such that the counter is able to accurately count the appropriate interval for the next successive stored sample.

Advantageously, the operator need not have any knowledge of the waveform to be recorded other than to know that its frequency content is below a very high maximum value and the approximate range of its amplitude. As noted, each channel both continuously samples its input signal and simultaneously records each selected sample and its "time-tag" all during extremely short intervals of time, i.e. close to the minimum conversion time of the A/D converter which is substantially shorter than the minimum period (or pulse width) of the input signals that are likely to be recorded. Consequently, the recorder can accurately record any input signal having a longer period (or pulse width) without any adjustment being made to the recorder. Furthermore, since the recorder relies on amplitude differences, rather than on a specific amplitude, in order to select those samples to be recorded, the exact amplitude of any specific sample is essentially immaterial to the recorder, and thus to the operator.

It is a feature of this invention to permit the sensitivity of the recording circuitry, in each channel of the waveform recorder, to be set to match the expected perturbation in the input signal applied thereto. Specifically, the sensitivity of each channel is varied through the application of the difference signal to a variable gain amplifier. As the gain is increased or decreased, so is the sensitivity. Since the gain, as well as each endpoint of the range, can be independently adjusted while the waveform recorder is in operation, this advantageously provides an operator with complete flexibility in independently tailoring the operation of each channel in the multi-channel recorder to the particular input signal applied thereto.

Another feature of the invention is to permit each or any selected subset of all of the channels in the waveform recorder to determine the points in time when all the channels simultaneously record a sample for all their respective input signals. Specifically, the "TAKE" return signal produced by the comparator in each channel is applied through a switch to the system control circuitry. All the switched "TAKE" return signals are effectively tied together. Within the system control circuity, a resultant "TAKE" data signal is generated and applied to each channel to cause it to store the current sample of its respective input signal. Consequently, at the occurrence of any switched "TAKE" return signal produced by any channel, all the channels simultaneously record data. If, however, the switch in any channel is appropriately positioned to disconnect the "TAKE" return signal generated by that channel from the system control circuitry, then that channel will record data only in response to a "TAKE" return signal generated by any other channel. Thus, all these switches can be appropriately set such that any one or more of the channels determine when all the channels record data.

Lastly, a further feature of this invention is to provide a multi-channel waveform recorder that can be readily expanded to accommodate any number of channels. This is readily accomplished by essentially connecting all the channels in parallel off various control lines, and buses emanating from the system control circuitry.

The invention may be clearly understood from a consideration of the following detailed description and accompanying drawing, in which:

FIG. 1 is an overall block diagram of the circuitry of a multi-channel electronic waveform recorder which embodies the teachings of the present invention;

FIG. 2 is a block diagram of the circuitry of data channel 1 shown in FIG. 1;

FIG. 3 is a block diagram of the circuitry of system control 20 shown in FIG. 1; and

FIGS. 4A and 4B are waveform diagrams showing typical timing relationships among various control signals occurring in the recorder during data recording and replaying operations, respectively.

To facilitate easy understanding, identical reference numerals are used to denote identical elements common to the figures.

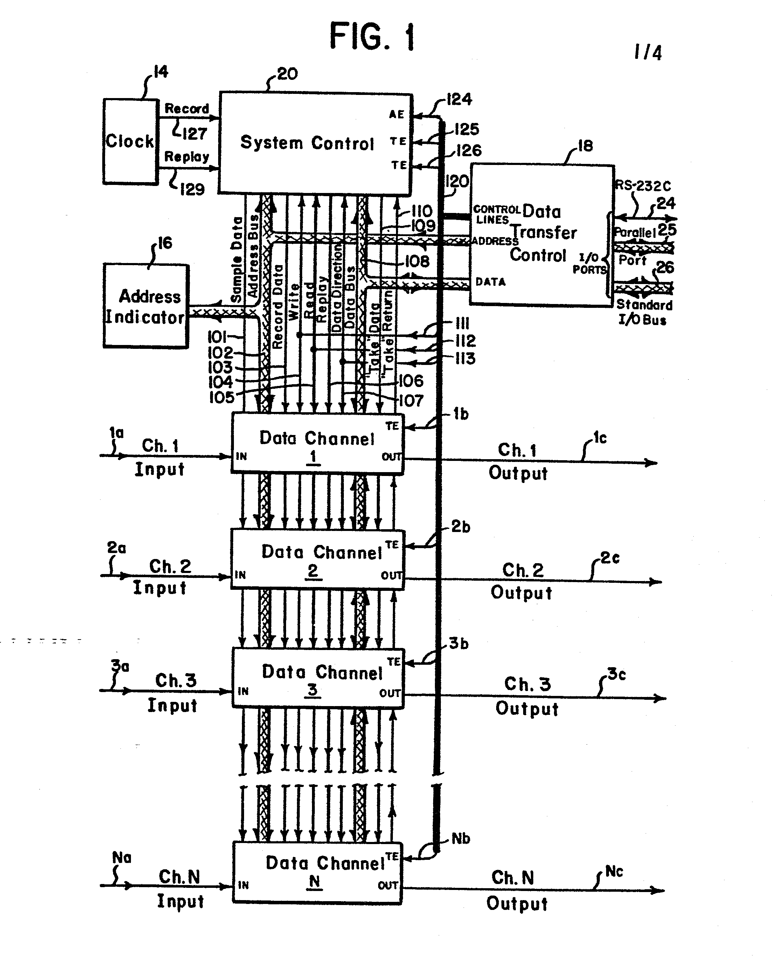

FIG. 1 depicts an overall block diagram of a multi-channel electronic waveform recorder which embodies the teachings of the present invention.

As shown, the waveform recorder is comprised of a plurality of N substantially identical channels; specifically data channel 1, data channel 2, data channel 3, ... , data channel N. Each data channel records the waveform of a signal applied to its input, e.g. data channel 1 records a corresponding input appearing on lead 1a, data channel 2 records a corresponding input signal appearing on lead 2a and so on. The signal applied to the input can be either analog or digital. During both recording and playback, each channel provides an analog output equivalent to that which it is presently or has just recorded; specifically, data channel 1 provides an analog output on lead 1c, data channel 2 provides an analog output on lead 2c and so on.

All the channels are connected in parallel to a plurality of control lines and buses -- specifically lines 101, 103-107, and 109 and 110 and buses 102 and 108 -- which together emanate from system control 20. Within system control 20, each of these lines and buses is driven by circuitry having a sufficiently high drive capability such that any requisite number of data channels can be connected in parallel without any significant attenuation occurring in any of the signals appearing on any of these lines or buses.

System control 20 controls the operation of each of the data channels. Specifically, for recording, each channel independently monitors its associated input signal and, based upon whether the difference in amplitude -- as will be discussed shortly -- between the current value of the input signal and that of the most recently stored sample exceeds a pre-selected range, the channel determines whether the current value is to be recorded. In particular, all the channels simultaneously sample respective input signals whenever a pulse appears on sample data line 101. The frequency of these pulses is determined by the frequency of the record clock pulses applied to system control 20, via lead 127, from clock 14.

In the event any channel determines that the current value of its input signal is to be recorded, it provides an appropriate signal to system control 20, via "TAKE" return line 110. In response to this signal, system control 20 applies appropriate pulses -- as will be discussed in detail shortly -- to "TAKE" data line 109, and record line 103. These pulses command each channel to simultaneously store the current sample of its associated input signal in a memory existing within that data channel at, more specifically, an address (location) specified by the address information then appearing on address bus 102. This address is appropriately incremented by system control 20 such that the next recorded sample of each input signal is stored at the next successive location in the memory within each data channel. Furthermore, the time-of-occurrence (commonly referred to as a "time-tag") for each recorded sample, is stored in a memory within system control 20 at, more specifically, a location having an address corresponding to that of the stored sample. This is discussed in greater detail below in conjunction with the discussion of system control 20.

In addition to controlling recording, system control 20 (shown in FIG. 1) also controls playback by all of the channels of the waveform stored in each. Specifically, to replay, i.e., read out the stored waveform and apply its analog equivalent to an output of the associated channel, system control 20 applies a train of clock pulses to replay clock line 106. The frequency of these pulses is determined by the frequency of replay clock pulses applied to system control 20, via lead 129, from clock 14. The frequency of the pulses can be adjusted by the operator to one of many pre-determined integral multiples or fractions of the recording rate, i.e., the frequency of the record clock pulses appearing on lead 127, depending upon the desired speed at which all the recorded waveforms are to be read out of their associated memories and whether that rate is to be faster, the same as or slower than the rate at which all the waveforms were recorded. By adjusting the frequency accordingly, the operator can appropriately expand or compress the time scale of all the recorded waveforms. For example, by appropriately adjusting the replay clock pulse rate, a very fast transient may be replayed at a sufficiently slow rate to allow an ordinary mechanical pen recorder to make a permanent and accurate record of this transient. Alternately, where the recorded waveform contains wide variations in frequency, several different replay clock pulse rates can be used in succession in order to appropriately expand or compress the time scale along various points in the recorded waveform.

Coincident with the application of the pulses to replay line 106, system control 20 also applies appropriate address information, via address bus 102, to the memory in every channel. The address information appearing on address bus 102 is appropriately incremented by system control 20 such that all the stored values for each waveform are read out in proper sequence from the respective memories. Furthermore, system control 20 permits the operator to set the starting address, at which replay will occur, to correspond to any location in the memory. This advantageously permits the operator to replay any desired selected portion of the stored waveforms. For example, if only one particular transient signal is of interest and the waveform occurring prior thereto is not, then the address at which replay will start can be set to correspond to the beginning of the transient. Each of the data channels -- as discussed in detail shortly -- uses a non-destructive random access memory (RAM) to store an recorded waveform which, in turn, advantageously permits the recorded waveform to be replayed as many times as desired.

Address indicator 16, which is connected to address bus 102, provides an indication of the current address information present on this bus. Illustratively, address indicator 16 may be comprised of simple well known combinatorial circuitry which feeds a plurality of display drivers and 7 segment digital displays for converting binary address information on address bus 102 into any convenient desired digital form, such as octal, hex or binary coded decimal (BCD), and then subsequently displaying it. This provides an indication of the current address and thus, by inference, the amount of each memory that has been used (or conversely is available for subsequent storage). A direct indication of the amount of consumed memory space is provided by an alternate address indicator in which the address information is first applied as input to a digital-to-analog (D/A) converter which, in turn, applies its analog output to one of many well known digital panel meters. By appropriately scaling the ouput analog voltage range of the D/A to, for example, 0 to +10V, so as to correspond to the lowest and highest locations in memory and appropriately energizing a decimal point on the display such that the display reads 0 to 1.0, then the digital panel meter will directly display the fractional amount of each memory that has been used up to that point for waveform storage. The remaining fractional amount of available memory can be readily obtained by subtracting the displayed amount from +1.0, either through electrical or other well-known means.

In addition, system control 20, in conjunction with data transfer control 18, permits digital information to be directly transferred between any memory in any data channel or the ("time-tag") memory in system control unit 20 and any external digital device, such as a computer. Specifically, data transfer unit 18 is connected to three standard bi-directional digital input/output (I/O) ports: serial data line 24 which is preferably RS-232C compatible, parallel multi-bit bus 25, and general purpose (input/output) interface bus 26 which is preferably compatible with the I.E.E.E. 488 standard. Typically, data transfer control 18 is comprised of a central processing unit (not shown), illustratively and preferably any one of a number of presently available and well known microprocessors, which is connected through commercially available and well known bi-directional communications circuits (also not shown) to the three I/O ports 24, 25 and 26. To transfer data bi-directionally between any of these ports and the memory in any of the data channels, the microprocessor is also connected to address and data buses 102 and 108; to system control 20 by control lines 124, 125 and 126; and to each data channel 1, 2, 3 ... N, by a respective control line 1b, 2b, 3b, ... , Nb, as well as by write line 104, read line 105 and data direction line 107, via leads 111, 112 and 113. All of these separate control lines from data transfer control 18 form cable 120. In the present embodiment, the connections between address bus 102 and data transfer unit 18 are through uni-directional buffers and thus only permit the latter to transfer output address information onto this bus. All the control lines in cable 120 are connected to standard digital outputs of the microprocessor contained within data transfer control 18.

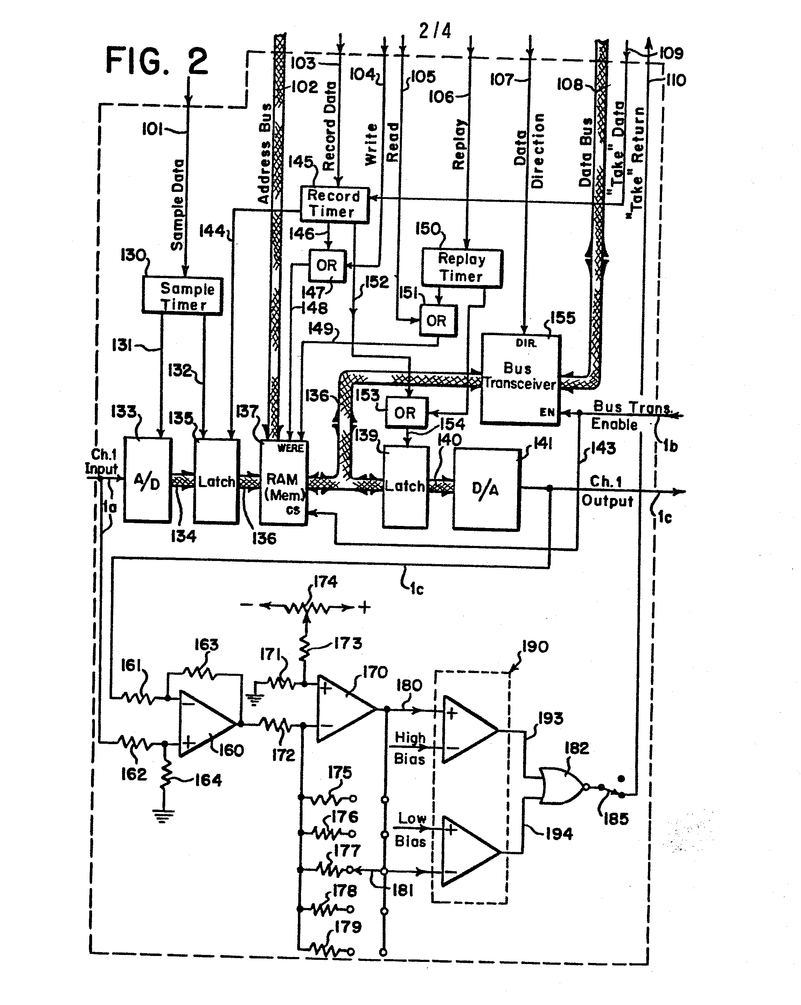

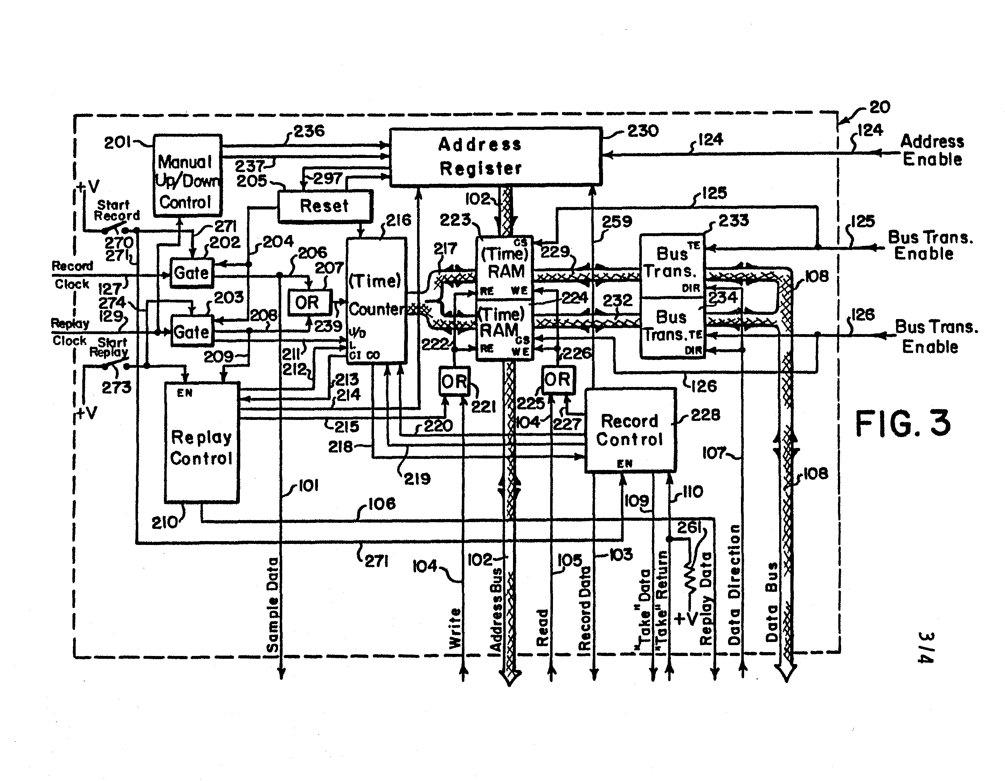

To transfer data to any of these ports from the memory in either system control 20 or in any of the data channels, data transfer control 18 first applies an appropriate level change, via lead 124, to the address enable (AE) input of system control 18. This disables the address generation circuitry and effectively disconnects it from address bus 102. Thereafter, data transfer control 18 applies the appropriate starting address to the address bus. It then applies an appropriate level to data direction line 107, via lead 113. This control line is connected as shown in FIGS. 2 and 3, to various bi-directional bus transceivers, which provide a bi-directional interface between all the RAM memories and the data bus, and functions to control the direction of the address and data flow between any of these memories and this bus. The level is set such as to permit data to be loaded onto data bus 108 by any of the RAM memories, via its associated bus transceiver. Once the appropriate level is set on data direction line 107, then the transceiver enable (TE) and chip select (CS) lines, associated with the desired RAM memory in either a data channel or the system control, is set by data transfer unit 18, via the particular line in cable 120, so as to select the RAM memory and enable the bus transceiver to transfer data from the selected RAM to the data bus. Since the system control contains two separate RAM's -- as previously noted and discussed in greater detail later -- and each data channel contains only one, two separate TE (and CS) lines, specifically line 125 and 126, are each connected to a separate RAM memory within system control 20, and one TE (and CS) line, specifically 1b, 2b, 2c, ... 2n, is connected to the RAM memory within each of the respective data channels 1, 2, 3, ... , N.

With the desired RAM selected and the appropriate bus transceiver enabled, data transfer control 18 energizes read line 105. Read line 105 and write line 104 are both effectively connected -- through OR gates as shown in FIG. 2 and 3 to each RAM memory and thereby
control the read and write cycles for all the RAM
memories.  Consequently, with the desired starting address
present on the address bus, the appropriate data direction
set, the desired RAM selected and the proper bus
transceiver enabled, the occurrence of a pulse on the read
line initiates a read cycle which results in the stored
sample in the desired RAM being transferred to data bus
108 and from there to data transfer control 18.  This
sample is then either stored locally within the data
transfer control or applied as output to one or more of
the three I/O ports 24, 25 or 26 depending upon
instructions provided to or previously stored within the
microprocessor comprising data transfer unit 18.  To
access values stored at a plurality of locations in the
selected RAM, first the address information is incremented
and second the data transfer cycle described above is
repeated for each such location.

The sequence for transferring data from any of
the I/O ports of data transfer unit 18 to any location
within a selected RAM memory, occurring within either the
system control or any data channel, is very similar to
that described above for transferring data from a selected
RAM to an I/O port.  Transferring information into RAM is
particularly useful if the waveform recorder is connected
to one or more analog recording instruments, e.g. chart
recorders, plotters or oscilloscopes, in that the waveform
recorder is then converted into a simple graphics device
which can take digital data from any of the three I/O
ports, store it and repeatedly display it in an analog
fashion.

Specifically, to transfer data to a selected RAM
memory, data transfer control 18 via lead 124, disables the address generation circuitry within system control 20. Thereafter, the data transfer control applies an appropriate level (opposite to that described above) to data direction line 113 to establish the proper direction of data flow through the bus transceivers, i.e. from the data bus to RAM memory. Thereafter, data transfer control 18 applies the appropriate initial address information to address bus 102, and applies the desired data to data bus 108. Next, data transfer control 18 selects the appropriate RAM memory and enables the appropriate bus transceiver through the associated bus transceiver enable and chip select line. Thereafter, data transfer control 18 applies a pulse to write line 104. This pulse initiates a RAM write cycle which stores the desired data in the selected RAM memory at the location specified by this initial address.

As previously noted, the waveform recorder is comprised of a number of independent data channels, each of which records a waveform applied to its input. For the sake of brevity, only one such data channel, specifically data channel 1 will now be discussed. A block diagram of the circuitry comprising this data channel is shown in FIG. 2.

In essence and as noted, this data channel records a waveform as a sequence of digital samples. Specifically, the data channel first samples the waveform at an extremely high speed, then compares the current value of this waveform to a previously -- preferably the most recently -- stored sample and determines the difference existing therebetween. If this difference exceeds a predetermined range, the data channel applies an appropriate control signal to the system control which, in turn, signals the data channel to store a current (new) sample.

In particular, a waveform to be recorded (hereinafter referred to as the input signal) is applied over lead 1a to data channel 1. Within the data channel, the input signal is first sampled by analog to digital (A/D) converter 133 at a rate determined by a sequence of clock pulses generated by the system control (see FIG. 1) and appearing on sample data line 101. Sample timer 130 generates, in response to illustratively the falling edge of each clock pulse appearing as sample data line 101, a pulse which is applied over lead 131 to cause A/D converter 133 to start a conversion. After a short predetermined interval of time has elapsed -- sufficient for A/D converter 133 to completely convert an analog sample into its digital equivalent and apply the result to bus 134, sample timer 130 applies a pulse, via lead 132, to latch 135 to load this current (new) digitized sample into the latch.

The overall speed of the waveform recorder in substantially influenced by the particular A/D converter that is used in each data channel. Conversion accuracy is determined by resolution, which is predicated upon the number of bits that are present in the output of the A/D converter. However, as the number of bits increases, the speed of the converter decreases. For example, a 12-bit A/D converter is generally slower than an 8-bit converter of the same type, and the 12-bit converter is generally faster than a 16-bit converter of the same type. With this in mind, a preferred A/D converter possessing both sufficient accuracy and a very short conversion time is the 12-bit A/D model number HI5712A manufactured by the Semiconductor Division of Harris Corporation (Harris).

This A/D converter possesses a conversion time of approximately 8 microseconds. Since the sampling rate of the data channel is chosen to be slightly less than the maximum throughput of the A/D, the rate of the clock pulses appearing on sample data line 101 is preferably chosen to be approximately 100kHz, i.e. at this rate a new sample occurs every 10 microseconds and is immediately thereafter stored in latch 135.

In the event the current sample of the input signal applied to data channel 1 is to be recorded, then data channel 1, in a manner to be described next, applies an appropriate level change to "TAKE" return line 110. This, in turn, causes the system control to apply an appropriate address to address bus 102 and appropriate pulses to record data line 103 and "TAKE" data line 109 which together -- in a manner to be described shortly -- cause the current sample to be stored in RAM memory 137 at a location specified by the address then appearing on the address bus.

Specifically, to determine whether the current sample of the input signal on line 1a is to be recorded within RAM memory 137, the input signal is continuously compared to the analog equivalent of the most recently stored sample of this signal. To accomplish this, the most recently stored sample within the RAM memory is temporarily stored in latch 139. The parallel output of this latch is applied over bus 140 to the input of digital to analog (D/A) converter 141 which, in turn, provides its analog equivalent on output lead 1c. The signal appearing on this lead (hereinafter referred to as the ouput signal) is preferably scaled to match the input signal by applying a well-known (but not shown) reference voltage of appropriate polarity and magnitude to D/A converter 141.

For purposes of the following discussion, the output signal will be assumed to have the same polarity as the input signal and scaled to match the input signal.

The difference between the output signal, i.e. the analog equivalent of the most recently stored sample, and the input signal is generated by operational amplifier 160. The values of all resistors 161, 162, 163 and 164 are chosen to be equal such that the absolute gain of amplifier 160 with respect to either of its input signals is equal to one. The specific value of any of these resistors is not critical so long as it is substantially below the input impedance of the amplifier.

To minimize any components of the signal produced by this amplifier which are attributable to common mode signals appearing on both inputs, amplifier 160 should preferably have a high common mode rejection ratio. One such amplifier is model number LM 321 manufactured by National Semiconductor Corporation.

The difference signal produced by amplifier 160 is amplified by amplifier 170 which is connected in an inverting configuration. The gain of amplifier 170 is dependent on the ratio of the resistance of a selected one of the resistors 175 through 179 to the resistance of resistor 172. Switch 181 is used to select the desired resistor and thereby set the gain of this amplifier to one of a number of pre-defined values. The output of amplifier 170 may be nulled to zero, so as to cancel offsets for example, by appropriately adjusting variable resistor 174 which provides a bias current through resistor 173 and resistor 171 and, in turn, causes a cuuent to flow at the positive input of the amplifier.

The amplified difference signal produced by amplifier 170 is fed, via lead 180, to window comparator 190. This comparator is preferably a single chip device, such as Harris Model No. 4905, which accepts two analog inputs and provides a digital signal compatible with TTL type logic. Plus and minus 15 volts and plus 5 volts are the required supply voltages for this chip. In operation, a window comparator senses whether the magnitude of an analog signal lies within a pre-selected range. Here, the range is established by reference d.c. potentials applied to both the high and low bias inputs to the comparator. Any signal appearing on lead 180 that has a magnitude that lies within the "window", i.e. between these bias levels, produces a low-level (logical "0") digital output on both of the outputs 193 and 194 of window comparator 190. Alternatively, should the difference signal on lead 180 possess a magnitude that lies outside the "window", i.e. either above the high bias value or below the low bias value, then a high-level (logical "1") digital output is applied to either of leads 193 or 194, respectively. The bias voltages are generally set equal amounts from zero. For example, the value of high bias may be set equal to +.5 volts, while that of low bias may be set to -.5 volts. If the difference signal applied, via lead 180, to window comparator 190 exceeds +.5V, then the signal on lead 193 would be high-level (logical "1"). Alternatively, if the signal on line 180 is more negative than -.5 volts, then the signal on lead 194 would also be high-level (logical "1"). However, if the difference signal appearing on lead 180 is within the "window" of +.5 volts, then both output signals on leads 193 and 194 are low-level (logical "0"). Either of the bias levels may be adjusted independently of the other by the operator through well-known potentiometers (not shown).

Both output signals generated by window comparator 190 are applied as inputs to NOR gate 182. This gate inverts these output signals such that any difference signal on lead 180 that lies outside the pre-selected "window", i.e. comparison range, produces a low-level (logical"0") output, thereby signalling the system control to record the current values of all the waveforms. The output of this gate is applied through switch 185 to "TAKE" return line 110. Gate 182 is preferably an open-collector type such that the outputs of any number of these gates can be tied to the "TAKE" return line and one of these outputs can pull this line down to a low-level. An appropriate "pull-up" resistor 261 is connected to the "TAKE" return line within the system control, as shown in FIG. 3.

If switch 185 is open (opposite position to that shown in FIG. 2), then data channel 1 is not able to select any sample to be stored but instead only stores the current sample based upon selections made by any of the other data channels.

By now, it is readily apparent that two analog signals, the input signal appearing on line 1a, and the output signal, appearing on line 1c, are continually compared. The value of the difference between these two signals, required to generate a low-level "TAKE" return signal on lead 110, is partly dependent upon the gain of amplifier 170. If the gain is set very high, then only a very small difference is necessary to generate a low-level "TAKE" return signal. For low values of gain, correspondingly larger differences are necessary. Differences as small as .1 percent of the maximum full scale input signal can be selected by appropriately setting switch 181. However, if noise is present on the input signal appearing on line 1a, then an excessive number of samples will be recorded. To eliminate this, the gain is reduced such that the necessary differences are increased to 2-5% of the full scale input signal. Alternatively, this low amount of gain may be used with less important waveforms, while a higher gain is used in conjunction with more important waveforms.

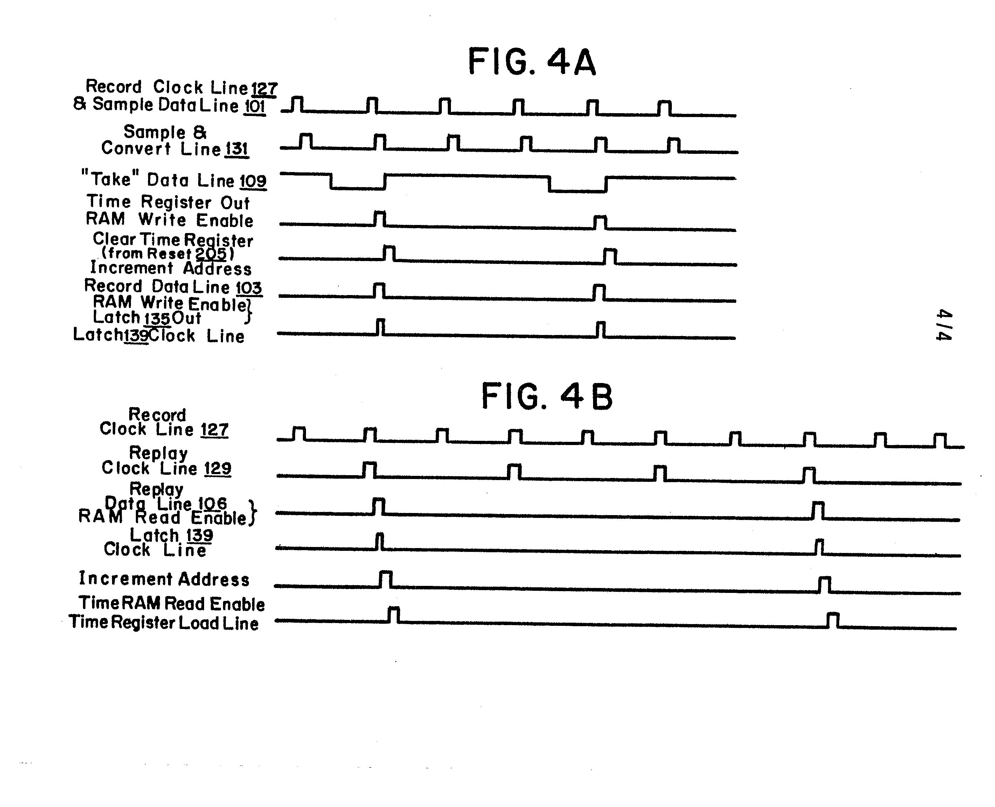

As previously mentioned, whenever a "TAKE" return signal occurs, "TAKE" return line 110 is pulled low by the output of NOR gate 182. At that point, the system control applies a pulse to "TAKE" data line 109 -- as shown in FIG. 4a -- followed at illustratively its rising edge by a pulse on record data line 103. Specifically, the pulse on the "TAKE" data line causes record timer 145 to apply an appropriate pulse to latch 135, via lead 144, which causes the latch to transfer its contents, i.e. the current (new) sample, via bus 136, to the parallel data inputs of RAM memory 137. Thereafter, the system control increments the address for each of the RAM memories to the next successive location and outputs this address onto address bus 102. Therafter, the pulse is applied to record data line 103 by the system control. Within the data channel, this pulse is applied to record timer 145, which, in turn, supplies a pulse via line 152, OR gate 153 and line 154, to latch 139. This pulse causes the latch to temporarily store the current sample appearing on line 136 and to apply it, via line 140, to the input of D/A converter 141. In addition to supplying a pulse to lead 152, record timer 145 also applies a pulse to lead 146. This latter pulse is applied, via OR gate 147 and lead 148, to RAM memory 137 to initiate a write cycle.

Display of all the recorded waveforms, as noted before, is effectuated by a series of pulses appearing on replay line 106 in conjunction with a sequence of incrementing addresses appearing on address bus 102. Specifically, whenever a replay operation is initiated, the system control applies an appropriate starting address to address bus 102. Each address is followed by a pulse applied to replay line 106. Within data channel 1, replay timer 150, in response to the pulse on replay line 106, first applies a pulse through OR gate 151 to the read terminal of RAM memory 137, followed a short time later -- sufficiently long for the read cycle to occur -- by a pulse applied to latch 139, through OR gate 153 and via lead 154. This latter pulse causes latch 139 to store the value read from the RAM memory and apply it, via bus 140, to D/A converter 141. This converter applies the analog equivalent of this value to line 1c as the channel 1 output signal. To provide sufficient waveform storage, RAM memory 137 is preferably comprised of 4K locations. Since A/D converter 133 provides 12 bits of information, 3 - 4K X 4bit RAM chips illustratively model number MB8168 manufactured by Fujitsu Limited (Fujitsu) are used. Since 12 bits are required to access 4K locations, address bus 102 is 12 bits wide.

As previously discussed, write line 104, read line 105 and data direction line 107 are used to transfer data between any of the three I/O ports, on the data transfer control shown in FIG. 1, and RAM memory 137, through initiation of an appropriate write or read cycle involving the memory.

By now, it is apparent that a loop circuit has been described in which the output signal on lead 1c is compared to the input signal on lead 1a. When a preselected difference occurs, a "TAKE" data signal causes the system control to output signals which "update" the channel 1 output signal. If during the short "update" time, the channel 1 input signal has not deviated from the updated output signal by more than the pre-selected amount, then the difference signal on lead 180 remains within the pre-selected "window" and the "TAKE" return signal from NOR gate 182 remains at a high-level (logical "1") state -- assuming, of course, that no other channel has caused "TAKE" return line 110 to assume a low-level state. Consequently, both the current sample from A/D 133 and data in latch 135 are replaced by the next successive sample. If during the updating process, a low-level signal remains on "TAKE" return line 110, then the A/D converter 133 to D/A converter 141 chain (in each data channel) continues to update at each successive pulse on record line 103 until the "TAKE" return data signal returns to a high level (logical "1") state.

A block diagram of system control 20 is shown in FIG. 3. As previously discussed, the system control provides several functions. First, it determines when each data channel is to sample its associated input signal and second, in response to a low-level signal on "TAKE" return line 110 caused by any of the data channels, it commands all the data channels to record the current value of all the input signals. System control 20 also controls the replaying of any or all of the waveform data stored within all of the data channels.

To control recording, system control 20 provides a stream of record clock pulses on sample data line 101 which, in turn, is connected to every data channel. These pulses are generated by clock 14 (shown in FIG. 1) and have a period slightly longer than the maximum conversion time of the A/D converter in each data channel. These pulses are then applied over lead 127 to the data input of gate 202 within system control 20.  Both the gate and record control 228 are enabled by a pulse provided by start record pushbutton 270 and applied to both via lead 271.  Once enabled, gate 202 applies the record clock pulses to both sample data line 101 and, via lead 206, to an input of OR gate 207.  From there, each record clock pulse is then applied over lead 239 to time counter 216 to increment its count by one.  This counter is illustratively 24 bits long and is used to count the number of record clock pulses occurring between successively stored samples in order to generate the appropriate "time-tag" information for each stored sample.  Each "time-tag" is stored in RAM memories 223 or 224 which together form a 4k x 24 bit RAM memory, preferably comprised of six 4k x 4 bit Fujitsu MB8168 RAM chips.

Whenever any data channel determines that the current sample of each waveform should be recorded, that channel, as previously discussed, causes "TAKE" return line 110, which is connected to all the data channels, to assume a low-level (logical "0") state.  In response to this low-level state, record control 228 produces a pulse on line 259 to cause address register 230 to increment the address information, appearing on address bus 102, to point to the next successive location in all the RAM memories both within the system control 20 as well as within each of the data channels.  At essentially the same time,  record control 228 also applies another pulse to time counter 216, via lead 220, to cause the counter to output its current contents to the data input of RAM memories 223 and 224 via bus 217.  Since time counter 216 is 24 bits long, bus 217 is 24 bits wide.  After a very short interval of time has elapsed, i.e. long enough to allow the data from counter 216 to stabilize on bus 217, record control 228 outputs a pulse to the write enable (WE) input of RAM memories 223 and 224, via lead 227, OR gate 225 and lead 226. This OR gate is used to supply a write enable pulse to the RAM, i.e. to initiate a write cycle, from either of two sources: record control 228 or read line 105 -- the latter of which, as shown in FIG. 1, is connected via cable 120 to data transfer control 18. After another short interval of time has elapsed, i.e. sufficient for the write cycle to be completed, reset 205 applies a pulse to counter 216 to reset its content to zero. Should the count in time counter 216 overflow prior to recording of any sample, then the counter applies a carry pulse output, via lead 218, to record control 228 which, in response thereto, initiates a recording operation in the same manner as if any data channel placed "TAKE" return line 110 in a low-level state.

In addition, whenever "TAKE" return line 110 assumes a low-level state, record control 228 also provides a low-level (logical "0") signal on "TAKE" data line 109 which is connected to every data channel. This low-level signal causes each data channel to store the current sampled value of its associated waveform by initiating, as previously discussed, a write cycle involving the RAM memory existing within the channel. To achieve the functions described above record control 228 is fabricated from illustratively well-known combinatorial logic gates and flip-flops.

Illustrative waveforms of various internal control signals which depict the sequence of operations involved in recording are shown in FIG. 4a. As illustratively shown, a sample is recorded between the occurrence of the first and second, and third and fourth record clock pulses.

At the conclusion of all recording, i.e. after all the locations in each of the RAM memories have been filled with stored data, the entire waveform recorder is automatically reset by reset circuit 205. This circuit applies appropriate reset pulses to both time counter 216 and address register 230 to reset their contents to zero, and to gates 202 and 203, via lead 204, to disable their outputs thereby preventing any further record clock pulses from reaching any of the data channels, via sample data line 101. To provide an indication that all the memory locations have been filled, address register 230 applies an appropriate carry out pulse to reset 205 via lead 297.

System control 20 also controls replaying of the waveform samples previously stored within the RAM memory in each of the data channels. To replay previously stored samples, clock 14 (shown in FIG. 1 and previously discussed) applies a stream of replay clock pulses to lead 129. As previously noted, the pulse rate of the replay clock pulses is preferably set, by manual controls (not shown) associated with clock 14, to an integral multiple (or fraction) of the pulse rate of the record clock pulses previously applied to lead 127, depending upon the degree of time compression or expansion desired in the replayed waveforms. If transient waveforms have been recorded, then the replay clock pulse rate is usually chosen to be a small fraction of the record pulse clock rate. In practice, replay clock pulse rates as slow as 1/10,000th that of the record clock pulse rate can be advantageously selected.

The replay clock pulses are applied to the input of gate 203 within system control 20. Both this gate and replay control 210 are enabled by a pulse provided by start replay pushbutton 273 and applied to both via lead 274. Well known (not shown) electrical and/or mechanical interlocks exist between start record pushbutton 270 and start replay pushbutton 273 to prevent the recording and replay circuits from being simultaneously enabled. Once enabled, gate 203 applies the replay clock pulses to an input of OR gate 207 via lead 208, to the up/down input of counter 216 via lead 211, and to replay control 210 via lead 209. Each replay clock pulse appearing at the output of OR gate 207 and applied to time counter 216 causes this counter to change its present count by one. In addition, gate 203, in response to each replay clock pulse, generates a level change which when applied to the up/down input of time counter 216 causes the counter to change its direction of counting, from up (incrementing) to down (decrementing).

During replay, time counter 216 is loaded -- in a manner to be described shortly -- with an appropriate "time-tag", associated with each previously stored sample, from RAM memories 223 and 224. Each pulse applied by gate 207 to time counter 216, decrements the "time-tag" in time counter 216 by one. Whenever the "time-tag" contained within time counter 216 reaches zero (indicated by a pulse appearing at its carry in, CI, input), time counter 216 applies a signal (pulse), via lead 213, to replay control 210. In response to this signal, replay control 210 applies a pulse to replay data line 106, which is connected to all the data channels. This causes all the data channels to read out of their respective RAM memories the previously stored sample located at the address specified by the address information then appearing on address bus 102, and to present the equivalent analog values of all these samples at respective output lines of the data channels.

After a short finite period of time has elapsed -- sufficient to permit all the RAM memories within all the data channels to complete their read cycles, replay control 210 applies a pulse, via lead 215, to address register 230 to cause it to increment its address to point to the next successive location in the RAM memories. Thereafter, the incremented address information is applied to address bus 102 and, in turn, to the address input of RAM memories 223 and 224. Replay control 210 then applies an appropriate pulse, via lead 215 and OR gate 221, to cause these RAM memories to read out the "time-tag" stored at the incremented address. After the read cycle is completed, the "time-tag" information is present on bus 217. After the signals on this bus have stabilized, replay control 210 applies a pulse, via lead 212, to time counter 216 to load the read-out "time-tag" information into the counter. This "time-tag" is then counted down by subsequently occurring replay clock pulses applied to replay clock lead 129. To achieve the functions described above, replay control 210 is fabricated from illustratively well-known combinational logic gates and flip-flops.

As is readily apparent, each sample stored within any data channel and its "time-tag" are both recorded simultaneously. In order to replay each waveform in the sequence in which it was recorded, the "time-tag" must first be loaded into time counter 216 and decremented to zero prior to read out of its corresponding stored sample. Hence, to start replay, the first stored sample (which incidentally is usually zero-valued) is read out and immediately converted to analog form and applied to the output line of the data channel. Thereafter, the "time-tag" associated with the second sample is then loaded into time counter 216 for subsequent decrementation. Replay of the remaining stored samples occurs according to the sequence described above.

Oftentimes, it may be desirable to start replay at an address which is not zero. To vary the starting address, manual up/down control 201 is fed by the replay clock pulses appearing on line 129. Through various manual adjustments, (not shown), manual up/down control 201 applies pulses via leads 236 and 237, to address register 230 to increment or decrement the address contained therein at a rate and direction chosen by the operator. A pulse on lead 236 changes the contents of the address register, and the level of the voltage on lead 237 specifies the direction (increment or decrement) of this change.

Bus transceivers 233 and 234 -- in conjunction with signals appearing on write line 104, read line 105, data direction line 107, address enable line 124 and bus transceiver enable lines 125 and 126 -- are all used to transfer stored waveform or "time-tag" values between any individual RAM memories within any of the data channels, (the waveform memories) or the RAM memory within system control 20 (the "time-tag" memory) and any of the three I/O ports associated with data transfer control 18 (shown in FIG. 1). As previously noted, data transfer control 18, prior to the occurrence of any data transfer, applies an appropriate level to address enable line 124, which within system control 20 shown in FIG. 3, is applied to address register 230. This level disables the address register thereby permitting data transfer control 18 to apply suitable address information to address bus 102. Bus transceiver enable lines 125 and 126 are used to enable either one of the bi-directional bus transceivers 233 or 234, respectively, to transfer data between either RAM memories 223 or 224 and data bus 108 in a direction determined by the signal then appearing on data direction line 107. Write and read lines 103 and 104, as previously discussed, route respective control pulses generated by data transfer unit 18, via corresponding gates illustratively OR gates 221 or 225 located within sytstem control 20, to initiate a write or read cycle involving any of these RAM memories.

Illustrative waveforms of various internal control signals which depict the sequence of operations involved in playback are shown in FIG. 4b. For purposes of illustration, the replay clock pulse rate has been chosen to be half that of the record clock pulse rate.

As can be readily appreciated from the foregoing description, an electronic waveform recorder embodying the principles of the present invention is not only readily able to accurately record a plurality of slowly varying waveforms over a long period of time, but it can also record occasional high frequency signals and/or transients with excellent accuracy. Ths recorder can advantageously replay a recorded waveform, in an analog form, any number of times and at any speed that is a multiple or fraction of the speed at which the waveform was originally recorded. The use of analog outputs advantageously permits any low speed mechanical waveform recorder or other analog device, e.g. a chart recorder, plotter or an oscilloscope, to be used as a graphic output device. Moreover, by appropriately varying the replay clock pulse rate, any desired amount of time compression or expansion can be achieved for playback. Thus, an electronic waveform recorder embodying the teachings of the present invention can effectively function as an interface (and/or buffer) between a plurality of high speed signals and low speed mechanical recorders by providing a vehicle through which theese recorders can mechanically record a plurality of signals having frequency components far higher than the maximum frequency response of the mechanical recorders.

In addition, the parallel interconnection of all the data channels readily permits an electronic waveform recorder, embodying the teachings of the present invention to be readily and inexpensively expanded to record any number of input waveforms by the simple connection of an additional number of data channels. The only requirement is that the various circuits which supply signals to these data channels possess sufficient drive capability to handle the desired number of interconnected data channels.

Furthermore, the electronic waveform recorder can be implemented using microprocessor technology in which the system control is embodied in one microprocessor and its peripheral chips, and each data channel is comprised of analog loop and a microprocessor -- with the latter handling data storage and communications. Alternatively, any one of a number of commercially available single chip microprocessors which incorporate on-chip A/D and/or D/A converters could be used within each data channel.

Although a specific illustrative embodiment has been shown and described herein, this merely illustrates the principles of the present invention. Many varied arrangements may be devised by those skilled in the art without departing from the spirit and scope of the invention.

CLAIMS:

1.  An electronic waveform recorder having at least one data channel (1,2,3...N) for recording an input signal (1a,2a,3a...Na), said data channel (1,2,3...N) comprising:
    means (133,135) responsive to the input signal (1a, 2a,3a...Na) and a clock pulse for producing a new digital sample which is substantially equivalent to the current value of said input signal (1a,2a,3a...Na) occurring at the time of the clock pulse,
    means (141) for producing an analog signal (1c,2c, 3c...Nc) substantially equivalent in value to a previously stored digital sample,
    means (160) for forming a difference signal proportional to the amplitude difference between said analog signal (1c,2c,3c...Nc) and said input signal (1a,2a,3a...Na), and
    means (137) responsive to said difference signal for storing said new digital sample whenever the magnitude of said difference signal exceeds a predetermined amount.

2.  An electronic waveform recorder according to claim 1 characterised in that said waveform recorder is further comprised of a plurality of substantially identical data channels (1,2,3...N) interconnected to a plurality of control lines and buses.

3.  An electronic waveform recorder according to claim 1 or 2 characterised in that said waveform recorder is further comprised of means (228) connected to each of said data channels (1,2,3...N) and responsive to a control signal generated by any of said data channels (1,2,3...N) for causing at least one of said data channels (1,2,3...N) to store the new digital sample associated therewith.

4.  An electronic waveform recorder according to claim 1, 2 or 3, characterised in that said waveform recorder is further comprised of means (223,224) for storing a plurality of values, each representing the time of occurrence of an associated sample stored in each of said data channels (1,2,3...N).

5. An electronic waveform recorder according to any preceding claim characterised in that said waveform recorder is further comprised of means (210) for reading any of said samples stored in any one of said data channels (1,2,3...N) and for providing an analog output signal in response thereto.

6. An electronic waveform recorder according to claim 5, characterised in that said reading means (210) is further comprised of means (201) for selectively setting the rate at which any of said stored samples are read to a desired integral multiple or fraction of the rate at which said sample was stored.

7. An electronic waveform recorder according to claim 5 or 6, characterised in that said reading means (210) is further comprised of means (216) for accessing the value representing the time of occurrence associated with a desired sample stored within at least one of said data channels (1,2,3...N), and means (216) for counting the accessed value to substantially zero prior to signalling said one data channel to read said desired sample.

8. An electronic waveform recorder according to any preceding claim, characterised in that said waveform recorder is further comprised of a plurality of input/ output ports and means connected to said data channels (1,2,3...N) and to said ports for transferring information therebetween.

9. An electronic waveform recorder according to any preceding claim, characterised in that said storing means (137) responsive to said difference signal is comprised of an analog comparator (190) for determining whether the magnitude of said difference signal exceeds the predetermined amount.

10. An electronic waveform recorder according to claim 9, characterised in that said comprator (190) is further comprised of means (170) for comparing said difference signal to a plurality of separate bias levels and for generating a plurality of resulting signals in response thereto, and gating means (182) for producing the control signal in response to a predetermined combination of said resulting signals.

11. An electronic waveform recorder according to any preceding claim, characterised in that said sampling means (133,135) is comprised of an analog to digital converter (133) and means (135) for temporarily storing each new digital sample.

12. An electronic waveform recorder according to any preceding claim, characterised in that said forming means (160) is comprised of an amplifier (160) for ascertaining the difference between the input signal (1a) and the analog signal(1c) and for multiplying said difference by a variable gain factor to produce said difference signal.

13. An electronic waveform recorder having a plurality of substantially identical interconnected data channels (1,2,3...N) characterised in that each data channel (1,2,3...N) records a corresponding input signal (1a,2a,3a...Na), each of said data channels (1,2,3...N) comprising:

means (133,135) responsive to an associated input signal (1a,2a,3a...Na) and a clock pulse for producing a new digital sample which is substantially equivalent to the current value of said input signal (1a,2a,3a...Na) occurring at the time of the clock pulse,

means (141) for producing an analog signal (1c,2c, 3c...Nc) substantially equivalent in value to a previously stored digital sample,

means (160) for forming a difference signal proportional to the amplitude difference between said analog signal (1c,2c,3c...Nc) and said input signal, and

means (137) responsive to said difference signal for storing said new digital sample whenever the magnitude of said difference signal exceeds a predetermined amount.

14. An electronic waveform recorder according to claim 13, characterised in that said waveform recorder is further comprised of means (228) connected to each of said data channels (1,2,3...N) and responsive to a control signal generated by any of said data channels (1,2,3...N) for causing at least one of said data channels (1,2,3...N) to store the new digital sample associated therewith.

15. An electronic waveform recorder according to claim 13 or 14, characterised in that said waveform recorder is further comprised of means (223,224) for storing a plurality of values, each representing the time of occurrence of an associated sample stored in each of said data channels (1,2,3...N).

16. An electronic waveform recorder according to claim 13, 14, or 15, characterised in that said waveform recorder is further comprised of means (210) for reading any of said samples stored in any one of said data channels (1,2,3...N) and for providing an analog output signal in response thereto.

17. An electronic waveform recorder according to claim 16, characterised in that said reading means (210) is further comprised of means (201) for selectively setting the rate at which any of said stored samples is read to a desired integral multiple or fraction of the rate at which said sample was stored.

18. An electronic waveform recorder according to claim 16 or 17, characterised in that said reading means (210) is further comprised of means (216) for accessing the value representing the time of occurrence associated with a desired sample stored within at least one of said data channels (1,2,3...N) and means (216) for counting the accessed value to substantially zero prior to signalling said one data channel to read said desired sample.

19. An electronic waveform recorder according to any one of claims 13 to 18, characterised in that said waveform recorder is further comprised of a plurality of input/output ports and means connected to said data channels (1,2,3...N) and to said ports for transferring information therebetween.

20. An electronic waveform recorder according to any one of claims 13 to 19, characterised in that said storing means (137) responsive to said difference signal is comprised of an analog comparator (190) for determining whether the magnitude of said difference signal exceeds the predetermined amount.

21. An electronic waveform recorder according to claim 20, characterised in that said comprator (190) is further comprised of means (170) for comparing said difference signal to a plurality of separate bias levels and for generating a plurality of resulting signals in response thereto, and gating means (182) for producing the control signal in response to a predetermined combination of said resulting signals.

22. An electronic waveform recorder according to any one of claims 13 to 21 characterised in that said sampling means (133,135) is comprised of an analog to digital converter (133) and means (135) for temporarily storing each new digital sample.

23. An electronic waveform recorder according to any one of claims 13 to 22, characterised in that said forming means (160) is comprised of an amplifier for ascertaining the difference between the input signal (1a) and the analog signal (1c) and for multiplying said difference by a variable gain factor to produce said difference signal.

24. An electronic multi-channel waveform recorder of the type having a plurality of substantially identical data channels (1,2,3...N) which are all substantially interconnected in parallel, wherein each of said data channels (1,2,3...N) records a corresponding input signal (1a,2a,3a...Na), in response to a control signal generated by any of said data channels, and wherein said waveform recorder is capable of both storing a plurality of values, each representing the time of occurrence of an associated sample stored in each of said data channels (1,2,3...N), and reading any of said stored samples and in response thereto providing an analog output signal (1c,2c,3c...Nc) substantially equivalent thereto, each of said data channels (1,2,3...N) comprising:
means (133,135) responsive to the input signal (1a,2a,3a...Na) and a clock pulse for producing a new digital sample which is substantially equivalent to the current value of said input signal (1a,2a,3a...Na) occurring at the time of the clock pulse,
means (141) for producing an analog signal (1c,2c,

3c...Nc) substantially equivalent in value to a previously stored digital sample,

means (160) for forming a difference signal proportional to the amplitude difference between said analog signal (1c,2c,3c...Nc) and said input signal (1a,2a,3a...Na), and

means (137) responsive to said difference signal for storing said new digital sample whenever the magnitude of said difference signal exceeds a predetermined amount.

25. An electronic multi-channel waveform recorder according to claim 24, characterised in that said reading means (210) is further comprises of means (201) for selectively setting the rate at which any of said stored samples is read to a desired integral multiple or fraction of the rate at which said sample was stored.

26. An electronic multi-channel waveform recorder according to claim 24 or 25, characterised in that said reading means (210) is further comprised of means (216) for accessing the value representing the time of occurrence associated with a desired sample stored within at least one of said data channels (1,2,3...N), and means (216) for counting the accessed value to substantially zero prior to signalling said one data channel to read said desired sample.

27. An electronic multi-channel waveform recorder according to claim 24, 25 or 26, characterised in that said waveform recorder is further comprised of a plurality of input/output ports and means connected to said data channels (1,2,3...N) and to said ports for transferring information therebetween.

28. An electronic multi-channel waveform recorder of the type having a plurality of substantially identical data channels (1,2,3...N) which are all substantially interconnected in parallel, wherein each of said data channels (1,2,3...N) stores a new digital sample of a corresponding input signal (1a,2a,3a...Na) in response to a control signal generated by any of said data channels (1,2,3...N), and wherein said waveform recorder is capable of both storing a plurality of values, each representing the time of occurrence of an associated sample stored in each of said data channels (1,2,3...N), and reading any of said stored samples, at a rate which is selectively set to a desired integral multiple or fraction of the rate at which said samples were stored, and in response thereto providing an analog output signal (1c, 2c,3c...Nc) substantially equivalent to said read sample, each of said data channels (1,2,3...N) comprising:

means (133,135) responsive to a corresponding input signal (1a,2a,3a...Na) and a clock pulse for producing the new digital sample which is substantially equivalent to the current value of corresponding input signal (1a,2a,3a...Na),

means (141) for producing an analog signal (1c,2c, 3c...Nc) substantially equivalent in value to a previously stored digital sample,

means (160) for forming a difference signal proportional to the amplitude difference between said analog signal (1c,2c,3c...Nc), and said input signal (1a,2a,3a...Na), and

means (137) responsive to said difference signal for storing said new digital sample whenever the magnitude of said difference signal exceeds a predetermined amount; and

said waveform recorder further comprising:

means (216) for accessing the value representing the time of occurrence associated with a desired sample stored within at least one of said data channels (1,2,3...N), and means (216) for counting the accessed value to substantially zero prior to signalling said one data channel to read out the desired sample.

29. An electronic multi-channel waveform recorder according to claim 28, characterised in that said waveform recorder is further comprised of a plurality of input/output ports and means connected to said data channels (1,2,3...N), and to said ports for transferring information therebetween.

30. An electronic multi-channel waveform recorder according to claim 28 or 29, characterised in that said storing means (137) responsive to said difference signal is comprised of an analog comparator (190) for determining whether the magnitude of said difference signal exceeds the predetermined range.

31. An electronic multi-channel waveform recorder according to claim 29 or 30, characterised in that said comparator (190) is further comprised of means (170) for comparing said difference signal to a plurality of separate bias levels and for generating a plurality of resulting signals in response thereto, and gating means (182) for producing the control signal in response to a predetermined combination of said resulting signals.

32. An electronic multi-channel waveform recorder according to claim 29,30 or 31, characterised in that said sampling means (133,135) is comprised of an analog to digital converter (133) and means (135) for temporarily storing each new digital sample.

33. An electronic multi-channel waveform recorder according to claim 29, 30,31 or 32, characterised in that said forming means (160) is comprised of an amplifier (160) for ascertaining the difference between the input signal (1a) and the analog signal (1c) and for multiplying said difference by a variable gain factor to produce said difference signal.

34. An electronic multi-channel waveform recorder of the type having a plurality of substantially identical data channels (1,2,3...N) which are all substantially interconnected in parallel, wherein each of said data channels (1,2,3...N) stores a new digital sample of a corresponding input signal (1a,2a,3a...Na) in response to a control signal generated by any of said data channels (1,2,3...N), and wherein said waveform recorder is capable of both storing a plurality of values, each representing the time of occurrence of an associated sample stored in each of said data channels (1,2,3...N), and reading any of said stored samples, at a rate which is selectively set to a desired integral multiple or fraction of the rate at which said samples were stored, and in response thereto providing an analog output signal (1c,2c,3c...Nc) substantially equivalent to said read sample, each of said data channels (1,2,3...N) comprising:

an analog to digital converter (133) responsive to a corresponding input signal (1a,2a,3a...Na) and to a clock pulse for producing the new digital sample which is substantially equivalent to the current value of the corresponding input signal (1a,2a,3a...Na) occurring at the time of the clock pulse,

a first latch (135) for temporarily storing said new digital sample,

a second latch (139) for temporarily storing a digital sample previously stored in a memory (137),

a digital to analog converter (141) responsive to the output of said second latch (139) for producing an analog signal (1c,2c,3c...Nc) substantially equivalent in value to the previously stored digital sample,

an amplifier (160) for ascertaining the difference between the corresponding input signal (1a,2a,3a...Na) and the analog signal (1c,2c,3c...Nc) and for multiplying said difference by a variable gain factor to produce a difference signal,

an analog comparator (190) for comparing said difference signal to a plurality of separate bias levels and for generating a plurality of resulting signals in response thereto,

a gate (182) for producing the control signal in response to a predetermined combination of said resulting signals, and

said memory (137) responsive to said control signal for storing said new digital sample whenever the magnitude of said difference signal exceeds a predetermined amount; and

said waveform recorder further comprising means (216) for accessing the value representing the time of occurrence associated with a desired sample stored within at least one of said data channels (1,2,3...N) and means (216) for counting the accessed value to substantially zero prior to signalling said one data channel to read out the desired sample, and

a plurality of input/output ports, and circuitry connected to said data channels (1,2,3...N) and to said ports for transferring information therebetween.

FIG. 1

FIG. 2

FIG. 3

# FIG. 4A

Record Clock Line 127 & Sample Data Line 101

Sample & Convert Line 131

"Take" Data Line 109

Time Register Out RAM Write Enable

Clear Time Register (from Reset 205)

Increment Address Record Data Line 103 RAM Write Enable} Latch 135 Out }

Latch 139 Clock Line

# FIG. 4B

Record Clock Line 127

Replay Clock Line 129

Replay Data Line 106 } RAM Read Enable} Latch 139 Clock Line

Increment Address

Time RAM Read Enable Time Register Load Line

0125883